# DEMANDE DE BREVET EUROPEEN

(11) **EP 1 741 495 A1**
(43) Date de publication de la demande: **10.01.2007**
(21) Numéro de dépôt: 06370022.3
(22) Date de dépôt: 04.07.2006
(51) Int. Cl.: B05D 7/24, B05D 3/02, C23C 16/56, C23C 18/12

(54) **Procédés d'obtention d'un matériau composite présentant une couche de pré-accroche catalytique**

(30) Priorité: 05.07.2005 FR 0507151
(71) Demandeur: UNIVERSITE DES SCIENCES ET TECHNOLOGIES DE LILLE, 59655 Villeneuve d'Ascq (FR)
(72) Inventeur: Guillou, Loic, 59000 Lille (FR); Supiot, Philippe, 59000 Lille (FR); Lecourtois, Véronique, 59000 Lille (FR)
(74) Mandataire: Hennion, Jean-Claude

(57) **Abrégé**

La présente invention concerne un procédé de traitement de pièces en acier inoxydable afin de préparer le dépôt et l'accroche, à leur surface, d'un solide qui intervient dans la formulation d'une espèce chimique active finale et/ou qui est susceptible de favoriser la fixation de ladite espèce chimique active.

Le procédé selon l'invention comprend :
a) une étape préalable de préparation de la pièce à traiter suivie de l'introduction de celle-ci dans un réacteur de dépôt PACVD ;
b) une étape de traitement sous post-décharge d'un plasma azote comprenant :
b1) une étape de conditionnement et de nettoyage de la pièce à traiter;
b2) une étape d'exposition de ladite pièce à traiter conditionnée et nettoyée à un mélange réactionnel comprenant de l'oxygène et le(s) précurseur(s) d'un polymère, conduisant à l'obtention d'un matériau composite suite au dépôt assisté par plasma d'une couche dudit polymère à la surface de ladite pièce.
Ledit procédé comprend en outre une étape c) de soumission dudit matériau composite à un traitement thermique afin d'obtenir, au moins en surface, une couche inorganique amorphe comportant notamment une espèce chimique active solide.

## Description

La présente invention concerne un procédé de traitement de pièces en acier inoxydable afin de préparer le dépôt et l'accroche, à leur surface, d'un solide qui intervient dans la formulation d'une espèce chimique active finale et/ou qui est susceptible de favoriser la fixation de ladite espèce chimique active. L'invention se rapporte également à un matériau composite obtenu notamment par la mise en oeuvre du procédé selon l'invention et à ses applications, notamment comme support de catalyse.

De nombreuses réactions chimiques menées à échelle industrielle s'accompagnent d'un fort dégagement d'énergie thermique. Cette exothermicité induit des différences de température au sein du milieu où a lieu la réaction (réacteur). Différents modes de conception des réacteurs permettent de limiter en partie cet inconvénient, mais celui-ci ne peut être totalement éliminé. De plus, toute solution visant traditionnellement à rationaliser le dégagement de chaleur créé par la réaction chimique s'accompagne de contreparties pouvant par exemple limiter la performance globale du système (activité et sélectivité). L'adjonction d'organes complémentaires destinés à réguler la température est donc nécessaire.

Pour évacuer l'excédent de chaleur produit par une réaction exothermique, l'utilisation d'échangeurs de chaleur est le seul recours disponible. Ceux-ci se caractérisent par une paroi conductrice séparant deux milieux différents. Le premier est le milieu réactif, c'est-à-dire celui où la réaction chimique et donc le dégagement de chaleur ont lieu. De l'autre coté de la paroi conductrice circule un fluide caloporteur qui va emmagasiner une partie de l'énergie dégagée par le milieu réactif et qui lui est transmise. Le fluide caloporteur réchauffé est ensuite évacué vers l'extérieur afin que l'énergie emmagasinée soit libérée et/ou réutilisée. Ces organes échangeurs de chaleur peuvent se présenter sous diverses géométries, telles que des systèmes multitubulaires ou des plaques corruguées par exemple. Si leur géométrie permet d'optimiser en partie le transfert de chaleur, c'est aussi la nature du milieu réactionnel qui va limiter ou favoriser l'évacuation de l'excès d'énergie dégagée.

Dans le cadre de réactions catalytiques hétérogènes, par exemple gaz-solide, des catalyseurs traditionnels conditionnés sous la forme de poudres, d'agglomérats, de granulés ou de pellets structurés n'offrent qu'une très faible surface de contact avec l'organe échangeur de chaleur. Dès lors il existe des limitations au transfert de l'énergie libérée par la synthèse chimique.

La problématique du greffage d'une espèce chimiquement active à la surface d'un substrat métallique a été étudiée de manière exhaustive pour de métaux tels que l'aluminium (De Sanctis O, Gomez L, Pellegri N, Duran A, 1995, Behaviour in hot ammonia atmosphere of SiO2-coated stainless steels produced by a sol-gel procedure, Surface and Coating Technology, 70 ; Thompson GE, 1997, Porous anodic alumina: fabrication, characterization and applications, Thin Solid Films 297, 192-201) ou les aciers modifiés (Haas-Santo K, Fichtner M, Schubert K, 2001, Preparation of microstructure compatible porous supports by sol-gel synthesis for catalyst coating, Applied catalysis A: General 220, 79-92).

Le greffage de la phase active à la surface oxydée du métal peut être obtenu par des méthodes diverses, telles que l'oxydation thermique, l'anodisation, le dépôt en phase vapeur, l'imprégnation à sec ou par voie humide, le spray plasma ou thermique. D'autres méthodes de dépôt moins agressives ont été développées autour des méthodes sol-gel, par exemple le revêtement par immersion. Ces méthodes présentent toutefois le désavantage de modifier la morphologie du dépôt vis-à-vis de la même espèce non déposée, avec des répercussions sur son activité ou sur le greffage ultérieur d'un autre composant actif à sa surface.

Il faut également citer les autres domaines concernés par l'accrochage d'espèces actives solide sur de l'inox : les barrières de diffusion aux gaz, la protection contre la corrosion humide (notamment pour les problèmes d'implants...) et la corrosion sèche (milieux sulfureux, hydrogénés tels que piles à combustibles), la protection mécanique ou la réduction de la friction.

La présente invention se propose de remédier aux limitations présentées par les systèmes d'accroches catalytiques hétérogènes en parois connus en proposant une solution permettant de ne pas hypothéquer les performances intrinsèques du catalyseur déposé par une quelconque influence parasitaire liée au protocole d'accroche.

L'objet de la présente invention est de proposer un matériau composite comportant une couche comprenant un solide qui intervient dans la formulation d'une espèce chimique active finale et/ou qui est susceptible de favoriser la fixation de cette dernière, ladite couche étant accrochée directement à la surface du substrat jouant entre autre le rôle d'un échangeur thermique. Ceci autorise un contrôle maximal de l'interface d'échange thermique et favorise donc une réaction chimique optimisée vis à vis des transferts thermiques. Il est à noter que cette application peut être généralisée à tout transfert de chaleur et peut donc être utilisée également lors des réactions chimiques endothermiques. Dans ce cas, le sens des flux thermiques est inversé, le fluide caloporteur cédant une partie de son énergie thermique à la paroi conductrice qui vient à son tour réchauffer le catalyseur.

A cet effet et selon un premier aspect, l'invention a trait à un procédé de traitement d'une pièce en acier inoxydable en vue du dépôt et de l'accroche à sa surface d'une couche polymérique qui compose ainsi un revêtement solide à la surface du substrat métallique, revêtement qui intervient dans la formulation d'une espèce chimique active finale et/ou qui est susceptible de favoriser la fixation de ladite espèce chimique, ledit procédé comprenant :
a) une étape préalable de préparation de la pièce à traiter suivie de l'introduction de celle-ci dans un réacteur de dépôt PACVD ;
b) une étape de traitement sous post-décharge d'un plasma azote comprenant :
   b1) une étape de conditionnement et de nettoyage de la pièce à traiter;
   b2) une étape d'exposition de ladite pièce à traiter conditionnée et nettoyée à un mélange réactionnel comprenant de l'oxygène et le(s) précurseur(s) d'un polymère, conduisant à l'obtention d'un matériau composite suite au dépôt assisté par plasma d'une couche dudit polymère à la surface de ladite pièce.

De manière caractéristique, le procédé selon l'invention comprend en outre une étape c) de soumission dudit matériau composite à un traitement thermique afin d'obtenir, au moins en surface, une couche inorganique amorphe comportant notamment une espèce chimique solide intervenant dans la formulation d'une espèce chimique active finale et/ou susceptible de favoriser la fixation de ladite espèce chimique active.

Le procédé de l'invention combine ainsi l'application d'une couche mince polymérique sur un substrat en acier inoxydable avec un traitement thermique destiné à modifier la structure de ladite couche polymérique au moins en surface, afin d'y éliminer tout composant organique, ceci rendant ladite couche polymérique modifiée apte à être utilisée directement en tant que phase active, support ou couche d'accroche de phase active de point de vue catalytique.

Selon un deuxième aspect, l'invention a pour objet un matériau composite formé d'un substrat en acier inoxydable à la surface duquel est accrochée une couche inorganique amorphe comportant notamment une espèce chimique active solide, ledit matériau composite étant obtenu notamment par la mise en oeuvre du procédé selon l'invention, et ses applications.

L'invention va maintenant être décrite en détails.

Selon un premier aspect, l'invention a trait à un procédé de traitement d'une pièce en acier inoxydable en vue du dépôt et de l'accroche à sa surface d'une couche comprenant notamment un solide qui intervient dans la formulation d'une espèce chimique active finale et/ou qui est susceptible de favoriser la fixation de cette dernière.

La pièce en acier inoxydable (inox 316, 304, 316L, 304L ou toute autre teinte d'alliage à base de fer et d'appellation inox) constituant le substrat est mise en forme selon des usages adaptés à son utilisation finale, préalablement à tout traitement. Elle est ensuite nettoyée, dégraissée dans l'acétone et gardée sous étuve à 110°C au moins pendant une durée suffisante à son complet séchage.

La pièce à traiter est ensuite fixée sur la platine d'un réacteur de dépôt chimique en phase vapeur assisté par plasma (PACVD) à l'aide d'un système adéquat. La platine est ensuite introduite dans le réacteur de dépôt PACVD, puis ce dernier est refermé. Il est possible de régler le positionnement de la platine à l'aide d'un système de positionnement contrôlé à l'aide d'un système adapté.

Le réacteur de dépôt PACVD est du même type que le dispositif décrit par le demandeur dans le document WO 94/18355. La figure 1 annexée représente de manière schématique la structure du réacteur de dépôt PACVD mis en oeuvre. Le réacteur 1 comprend quatre zones: le générateur de plasma 2, le système d'injection des gaz 3, la chambre de dépôt 4, l'auxiliaire de pompage 5.

La ou les pompes 5 permettent de mettre l'enceinte du réacteur sous basse pression. De cette façon, les équilibres liquide-vapeur des espèces chimiques utilisées au cours du procédé sont déplacés en faveur de la vaporisation des composés. La pression au sein du réacteur 1 peut être suivie et contrôlée en permanence à l'aide de sondes de mesure 6 (sondes capacitive 6a et Pirani 6b).

Le système d'injection des gaz 3 alimente une conduite d'alimentation 7 en verre et d'une buse coaxiale 8 du même matériau. La conduite principale 7 est alimentée en azote à l'aide d'un débitmètre massique régulateur 3a. La buse coaxiale 8 est alimentée en oxygène ou en composés chimiques vaporisés nécessaires au traitement des pièces inox ou en un mélange de ces gaz à l'aide des débitmètres massiques 3b et 3c respectivement.

La source du plasma est un applicateur coaxial excité par un générateur micro-ondes, radio-fréquences ou à courant continu pulsés ou non. Une section de la conduite d'azote est soumise au rayonnement micro-onde en amont de la chambre de dépôt 4.

La buse 8 et la conduite d'azote 7 débouchent sur la chambre de dépôt 4 où a été placée la pièce à traiter 9.

### Etape de conditionnement et de nettoyage de la pièce à traiter sous post-décharge d'un plasma azote et/ou d'un plasma azote/oxygène

Dans un premier temps, l'enceinte du réacteur 1 de dépôt est mise sous basse pression à l'aide des systèmes de pompage. Cette étape, opérée au vide résiduel obtenu à l'aide des précédents systèmes de pompage, permet d'atteindre une pression favorisant une désorption grossière des espèces éventuellement présentes en surface de la pièce à traiter 9. L'injection périodique d'azote peut permettre de favoriser la désorption et ainsi de diminuer le temps nécessaire à l'obtention d'une pression adaptée à la suite du processus.

Lorsque la pression requise est atteinte, le débit d'azote est réglé à une valeur compatible avec les conditions nécessaires au dépôt. Puis, le générateur micro-onde est allumé et réglé de façon à obtenir une puissance donnée. Cette opération génère une zone d'ionisation et une excitation au sein du gaz qui s'accompagne au niveau de la zone irradiée d'une forte luminosité. Ce milieu ionisé entretenu par la décharge micro-onde est le plasma à proprement parler. Seul le gaz excité est transporté par le flux. Le gaz quitte de façon plus ou moins progressive une zone ionisée puis atteint la zone de dépôt. Ainsi, son état au niveau de la zone de dépôt correspond à celui d'une post-décharge d'un plasma d'azote en écoulement.

Lorsque la pièce à traiter 9 se trouve dans cette zone de post-décharge, elle est progressivement nettoyée par le biais d'un décapage chimique induit par les espèces radicalaires d'azote présentent dans le flux gazeux. Ce décapage sous post-décharge d'azote est maintenu un temps suffisant pour éliminer toute molécule non désirée en surface du substrat à traiter 9. Une autre configuration peut être utilisée s'appuyant sur une post-décharge d'un plasma dans le mélange N₂ et O₂, toujours avec les mêmes paramètres de fonctionnement.

### Etape d'exposition de la pièce à traiter conditionnée et nettoyée à un mélange réactionnel comprenant de l'oxygène et le(s) précurseur(s) d'un polymère en quantités variables

La pièce 9 préalablement décapée est ensuite exposée au mélange réactionnel permettant le dépôt de films polymériques à sa surface. Ceci se fait sans remise à l'air de l'échantillon prétraité.

Les débits d'oxygène et de précurseur de polymère sont réglés. Ce mélange gazeux est injecté via la buse coaxiale 8 située en amont de la chambre de dépôt 4. Cette injection peut se traduire par l'apparition d'un cône d'une luminosité différente de celle du gaz en post-décharge en raison des réactions avec les vecteurs énergétiques de la post-décharge.

Le précurseur polymérique est un composé ou un mélange gazeux, qualifié de monomère et constitué d'espèces sélectionnées parmi les alkoxysilanes, siloxanes et/ou silazanes.

Dans un mode préféré de réalisation, le précurseur polymérique employé est le tétraméthyldisiloxane (TMDSO), une molécule présentant un pont oxyde entre deux atomes de silicium. Ces atomes portent de plus chacun deux groupements méthyle et un atome d'hydrogène. Lors de son exposition à l'azote excité de la post-décharge, le TMDSO est fragmenté en diverses espèces radicalaires extrêmement réactives. Celles-ci réagissent entre elles, avec l'oxygène et l'azote radicalaire présents dans le mélange gazeux et avec le métal constitutif de la pièce à traiter 9.

Dans ce dernier cas, un ancrage, notamment sur les sites « Fers ou Chromes » oxydés présents en surface de l'inox, permet la tenue du dépôt polymérique par accroche moléculaire de fragments organo-silicés de différentes tailles. D'autres fragments, recombinés ou non, viennent ensuite s'accrocher à ces points. A partir de ces ancrages, un réseau plus ou moins ramifié de filaments moléculaires constitués principalement de chaînes à base de - (CH₃)₂SiO- dans l'exemple préféré de réalisation va croître. L'enchevêtrement de ces filaments ainsi que leur réticulation mènent à l'obtention de dépôts dont la morphologie est celle de films polymériques amorphes ou faiblement structurés. L'épaisseur des films obtenus n'est fonction que du temps d'exposition au spray O₂ et TMDSO, tous les autres les paramètres restant identiques par ailleurs.

Une autre configuration peut être utilisée s'appuyant sur une post-décharge d'un plasma dans le mélange N₂ et O₂, toujours avec les mêmes paramètres de fonctionnement.

On obtient ainsi un matériau composite comportant une couche de polymère accrochée à la surface de la pièce à traiter 9.

### Etape de décharge du matériau composite

Le matériau composite peut éventuellement être exposé à un flux d'azote, d'oxygène ou à un mélange en proportions quelconques de ces deux gaz. Cette étape à lieu à la suite du dépôt PACVD, dans les mêmes conditions que pour l'étape de conditionnement et de nettoyage de la pièce à traiter sous post-décharge d'un plasma azote sans remise à l'air. Les paramètres du dépôt peuvent être conservés ou modifiés à l'exception de l'injection de monomère qui est coupée. Une autre configuration peut être utilisée s'appuyant sur une post-décharge d'un plasma dans le mélange N₂ et O₂, toujours avec les mêmes paramètres de fonctionnement. Ces expositions permettent entre autre un léger décapage de la surface, une réticulation par insertion d'oxygène, une modification des propriétés plastiques du film polymérique ou de ses propriétés physico-chimiques de surface, ces modifications pouvant aussi bien affecter le matériau à coeur selon les paramètres de post-décharge retenus.

### Etape de vieillissement du matériau composite

Le matériau composite ayant éventuellement subi l'étape de déchargement est alors remis à l'air puis retiré du réacteur de dépôt. Le film déposé peut encore évoluer : en effet, la cinétique de réticulation et de polymérisation est relativement lente. Ainsi après quelques minutes, il existe encore une activité chimique au sein et en surface du film déposé.

Afin de limiter la dégradation du film, la pièce est donc retirée au plus vite du réacteur et stockée en enceinte confinée et sous atmosphère contrôlée pour vieillissement, au moins le temps nécessaire à la disparition de l'activité résiduelle.

### Etape de soumission dudit matériau composite à un traitement thermique

La pièce déposée et stabilisée forme une catégorie de matériau composite présentant sur un substrat de type inox une couche solide constituée à majorité d'un polymère plus ou moins réticulé à base de silicium, d'oxygène, de carbone, d'azote et/ou d'hydrogène, principalement, en proportions variables selon les paramètres de dépôt précédemment employés. Ce polymère adhère à la surface métallique. Néanmoins sa composition peut présenter certaines propriétés physicochimiques contribuant à le rendre impropre à une utilisation directe en tant que phase active, support ou couche d'accroche de phase active vis-à-vis d'applications catalytiques dans certains cas. De plus, ce matériau peut se montrer sensible aux effets de température. En milieu oxydant notamment, il se dégrade de façon irréversible. Ceci induit une modification de sa surface et/ou de sa structure interne pouvant modifier ses propriétés physico-chimiques et mettre en péril sa tenue mécanique si les conditions de dégradation ne sont pas contrôlées.

Afin d'éliminer toute composante indésirable de la couche déposée en surface de l'inox, et d'obtenir un film de type « céramique » sans hypothéquer la stabilité mécanique du composite, ce dernier est soumis à un traitement thermique sous conditions contrôlées.

Le demandeur a constaté que, dans ces conditions, le film se trouvant à la surface du matériau composite conserve de bonnes propriétés d'adhésion à son support en acier, et ce même lorsqu'il est soumis à des conditions extrêmes.

Le traitement thermique du matériau composite consiste en la calcination des échantillons sous air, dans un four à moufles par exemple et sous une rampe de température contrôlée. Une vitesse de calcination sélectionnée est conservée jusqu'à obtention d'une température désirée qui peut être maintenue plusieurs minutes ; ceci permet une minéralisation contrôlée du film polymérique initial.

La température de calcination peut varier entre 450 et 900°C. Le temps de calcination varie de 1h à 5h environ. Selon les conditions de calcination utilisées, la minéralisation de la couche polymérique du matériau composite peut être partielle ou totale.

Dans ce dernier cas de figure, et pour le cas particulier d'une couche polymérique de type -[(CH₃)₂SiO]ₙ-, ladite couche ne se compose plus que de silicium et d'oxygène dans une composition atomique surfacique proche de celle d'une silice. Néanmoins, la structure interne peut conserver la trace du squelette polymérique obtenu par les traitements plasma précédents.

Le matériau amorphe (SiOₓ) issu de la calcination présente une bonne résistance au stress mécanique et, qu'il soit soumis à un débit gazeux tangentiel élevé (>50L/minute) ou à des chocs thermiques répétés de forte température (1000°C/ambiante), continue d'adhérer à la surface métallique du substrat.

La méthode séquentielle de dépôt PACVD de monomère sélectionné sous post-décharge d'azote combinée à un traitement thermique permet l'obtention de films inorganiques à base de formes oxydées de silicium en surface d'une pièce en inox. Ces films d'épaisseur contrôlée conservent de bonnes propriétés d'adhésion et masquent complètement le substrat même s'ils sont soumis à des conditions extrêmes.

Testés dans un réacteur catalytique à paroi, ces films additionnés, par un moyen adéquat, de composés à base de cobalt, présentent une activité chimique en synthèse d'hydrocarbures par synthèse dite de Fischer-Tropsch. Les performances de cette réaction se trouvent améliorées par rapport à celles obtenues pour un même composé à base de cobalt employé dans un réacteur tubulaire à lit fixe de conception plus classique. Les films modifiés déposés s'avèrent être très actifs en réaction et stables même après 700 heures d'utilisation.

Selon un deuxième aspect, l'invention a pour objet un matériau composite formé d'un substrat en acier inoxydable à la surface duquel est accrochée une couche inorganique amorphe comportant notamment une espèce chimique active solide, ledit matériau composite étant obtenu notamment par la mise en oeuvre du procédé selon l'invention, et ses applications, notamment comme support de catalyse.

Des films épais d'un polymère dérivé du monomère et/ou mélange de monomères sélectionné(s) ont été déposés, suivant le procédé de l'invention, sur un substrat en acier inoxydable. Sous les conditions employées, ces films sont composés majoritairement de chaînes polymériques entremêlées. La présence de groupements organiques résiduels issus du monomère initial peut induire entre autre une forte hydrophobie des surfaces. Un traitement thermique permet notamment d'éliminer ces résidus, indésirables au regard de l'application principale recherchée, sans affecter à faible température la nature profonde du matériau, en raison d'un contrôle diffusionnel d'accès des gaz dans les couches profondes du matériau. A basse température, le matériau présente alors une structure multicouches: sur le substrat métallique a été greffée une couche organo-silicée. Cette dernière est recouverte d'un matériau minéral dérivé d'un oxyde de silicium faiblement réticulé.

A haute température, l'intégralité du revêtement polymérique obtenu par dépôt PACVD est minéralisée. Il se structure comme une seule couche minérale greffée à la surface du substrat métallique. Une plus forte réticulation des chaînes polymériques peut apparaître au-delà de 800°C environ. D'autre part, même lorsqu'il est soumis à un stress mécanique important, tels que des chocs thermiques répétés ou une exposition à un débit gazeux tangentiel de très forte amplitude, le film conserve son pouvoir couvrant du substrat et reste ancré à la surface de ce dernier.

Destinés à un usage de support catalytique ou de couche de liaison entre le substrat et un catalyseur, ces films nécessitent d'être traités de façon à être totalement minéralisés (soit un traitement à une température supérieure à 600°C environ). L'acier inoxydable entièrement recouvert ne devrait pas prendre part à la réaction chimique envisagée pour l'espèce active dans les conditions requises (par exemple en induisant des réactions secondaires ou parasites). L'absence de propriétés physicochimiques de surface indésirables (hydrophobie par exemple) permet d'envisager l'emploi de ces films comme supports catalytiques imprégnés ou comme phases d'accroche d'un catalyseur venant être greffé à leur surface, riche en silicium, par tout moyen jugé adapté par l'homme de l'art (voir par exemple les méthodes proposées par Barrera EC, Viveros TG, Morales U, Preparation of selective surfaces of black cobalt by sol-gel process, **1996**, WREC).

D'autres applications possibles des matériaux composites comportant ces films sont : intermédiaire favorisant l'accroche d'un catalyseur ; barrière à la diffusion des gaz ; protection contre les corrosions sèche ou humide ; couche de protection mécanique ; couche de lubrification mécanique de pièces inox de convoyage.

L'invention sera mieux comprise à la lecture des exemples de réalisation suivants, non limitatifs.

### Exemple 1. Exemple de conditions de préparation d'échantillons

Des échantillons en acier inoxydable de teinte 316L (aux dimensions de 20x20 et 40x20mm découpés dans des feuillets laminés de 2 mm d'épaisseur) ont été dégraissés dans de l'acétone (99,5% de pureté) et séchés en étuve à 110°C pendant une nuit. Ils ont ensuite été stockés en dessiccateur en attendant leur utilisation.

### Exemple 2. Exemple de conditions de chargement

Des échantillons préparés selon l'exemple 1 ont subi l'étape de dépôt PACVD à température ambiante sous 5 mbar de pression. Les débits gazeux ont été préréglés aux valeurs nominales de : 1,8 L/min pour l'azote N₂, 5 mL/min et 25mL/min pour le monomère et l'oxygène O₂ sous conditions normales de température et de pression respectivement. Le monomère retenu dans cet exemple est le tétraméthyldisiloxane (TMDSO). Les échantillons ont été initialement préalablement traités sous post-décharge ce qui autorise un nettoyage en profondeur du substrat métallique.

### Exemple 3. Exemple de conditions de dépôt de polymère

Certains échantillons préparés selon l'exemple 2 ont été conservés 15 minutes sous les mêmes conditions de post-décharge d'azote adjoint des débits additionnels de O₂ et TMDSO tels que préréglés dans l'exemple 2. Après exposition à des temps variables, les flux ont été interrompus. Les échantillons ont ensuite été sortis promptement du réacteur PACVD et stockés une nuit en dessiccateur.

### Exemple 4. Exemple de conditions de déchargement

Certains échantillons préparés selon l'exemple 3 ont été conservés 15 minutes sous les mêmes conditions de débit à l'exception du TMDSO dont le flux a été interrompu. Ils ont ensuite été sortis promptement du réacteur PACVD et stockés une nuit en dessiccateur.

### Exemple 5. Exemple de conditions de stockage

Certains échantillons préparés selon l'exemple 3 ont été sortis promptement du réacteur PACVD et stockés une nuit en dessiccateur. Certains échantillons ont été caractérisés par photo-spectroscopie des électrons X (SPX) (tableau 1).

**Tableau 1**

| **échantillon** | **Formule de surface (déduite de SPX)** |
|---|---|
| polymère | SiC_{1,08}O_{1,15} N_{0,04} |
| Traitement (450°C) | SiC_{0,12}O_{1,67} |
| Traitement (650°C) | SiC_{0,05}O_{1,8} |
| Traitement (900°C) | SiC_{0,01}O_{1,82} |

### Exemple 6. Exemple de conditions de traitement thermique

Certains échantillons préparés selon l'exemple 5 exposé ont subi un traitement thermique sous air à des températures de 450, 650 et 900°C respectivement. Une rampe de programmation de température de 5°C/min a été utilisée. Les températures finales furent maintenues pendant une heure au moins pour les deux dernières températures mentionnées. Divers échantillons ont été traités à la température de 450°C, le pallier final étant conservé exactement 1, 2, 3, 4 et 5 heures. Certains échantillons ont été caractérisés par une analyse de surface par SPX (tableau 1).

### Exemple 7. Exemple de mesure d'épaisseur

Des échantillons sélectionnés parmi les échantillons issus de l'exemple 5 ont été caractérisés par une mesure d'épaisseur effectuée à l'aide d'une sonde à courants de Foucault étalonnée. Chaque épaisseur est la mesure moyenne effectuée à partir de 5 points de référence selon le protocole proposé par Azzouz (Azzouz N, Belmokre K, Taallah H, Pagetti J, 1999, Etude de l'influence du mode d'anodisation sur la cinétique de croissance des films d'alumine en milieu acide sulfurique, Canadian J. of Chem. Eng. 77*).* La précision est de l'ordre de 1µm.

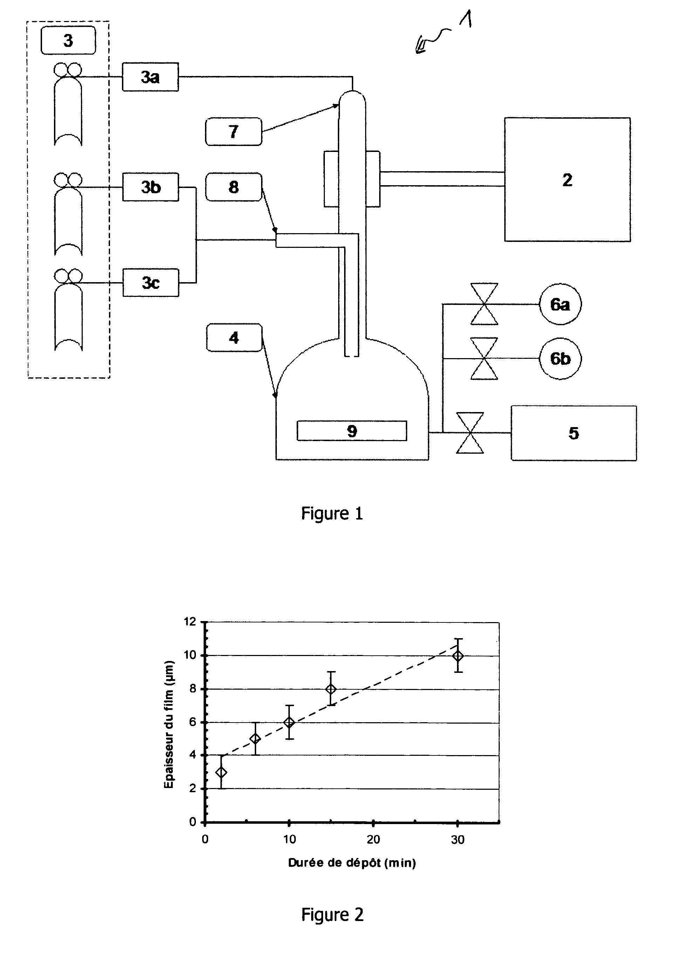

La variation d'épaisseur apparaît comme étant une fonction globalement linéaire du temps tout autres paramètres égaux par ailleurs (figure 2 annexée).

### Exemple 8. Exemple d'évaluation de tenue mécanique

La perte de masse avant et après exposition d'échantillons traités selon l'exemple 5 à flux d'air tangentiel a été mesurée (50 L/minute dans l'exemple).

Un échantillon ayant été traité selon l'exemple 5 a été soumis à une calcination de 30 minutes à 1000°C puis remis à l'atmosphère à la température de la pièce induisant un choc thermique violent. Ce cycle a été répété quatre fois sur le même échantillon. La perte de masse de l'échantillon refroidi avant et après exposition à flux d'air tangentiel a été mesurée entre chaque choc thermique.

Les variations de masse enregistrées pour les différents cas sont négligeables et de l'ordre de l'incertitude de la balance de précision employée (10⁻⁷kg).

## Revendications

1. Procédé de traitement d'une pièce en acier inoxydable en vue du dépôt et de l'accroche à sa surface d'une couche comprenant notamment un solide qui intervient dans la formulation d'une espèce chimique active finale et/ou qui est susceptible de favoriser la fixation de ladite espèce chimique, ledit procédé comprenant :
a) une étape préalable de préparation de la pièce à traiter suivie de l'introduction de celle-ci dans un réacteur de dépôt PACVD ;
b) une étape de traitement sous post-décharge d'un plasma azote comprenant :
b1) une étape de conditionnement et de nettoyage de la pièce à traiter;
b2) une étape d'exposition de ladite pièce à traiter conditionnée et nettoyée à un mélange réactionnel comprenant de l'oxygène et le(s) précurseur(s) d'un polymère, conduisant à l'obtention d'un matériau composite suite au dépôt assisté par plasma d'une couche dudit polymère à la surface de ladite pièce,
**caractérisé en ce qu'**il comprend en outre une étape c) de soumission dudit matériau composite à un traitement thermique afin d'obtenir, au moins en surface, une couche inorganique amorphe comportant notamment une espèce chimique active solide.

2. Procédé selon la revendication 1 comprenant en outre une étape de déchargement et/ou de vieillissement du matériau composite préalablement à l'étape de traitement thermique.

3. Procédé selon l'une des revendications 1 et 2 dans lequel la préparation des pièces à traiter se fait par tout moyen de mise en forme ou d'usinage adapté, dégraissage et séchage.

4. Procédé selon l'une quelconque des revendications 1 à 3 dans lequel le conditionnement et le nettoyage de la pièce à traiter, placée dans une zone de dépôt du réacteur de dépôt PACVD comprenant un générateur de micro-ondes, radio-fréquences ou à courant continu pulsés ou non, consiste en :
i. réduire la pression à l'intérieur du réacteur de dépôt de sorte à favoriser la désorption des espèces éventuellement présentes à la surface de la pièce à traiter ;
ii. injecter périodiquement de l'azote afin de favoriser la désorption et de moduler la pression ;
iii. produire, au moyen du générateur de micro-ondes, radio-fréquences ou à courant continu pulsés ou non, un plasma apte à être transporté ou sa post-décharge en écoulement vers la zone de dépôt de sorte à nettoyer progressivement la pièce à traiter.

5. Procédé selon l'une quelconque des revendications 1 à 4 dans lequel le précurseur polymérique de l'étape b2) est un composé ou un mélange gazeux, qualifié de monomère et constitué d'espèces sélectionnées parmi les alkoxysilanes, siloxanes et/ou silazanes.

6. Procédé selon l'une quelconque des revendications 2 à 5 dans lequel le déchargement du matériau composite obtenu à l'étape b2) consiste à exposer ce matériau composite à l'azote, à l'oxygène ou à un mélange azote et oxygène, sans ajout de monomère, en présence ou en l'absence d'une post-décharge du plasma.

7. Procédé selon l'une quelconque des revendications 2 à 6 dans lequel le vieillissement du matériau composite ayant éventuellement subi l'étape de déchargement selon la revendication 6 consiste en le stockage de ce matériau composite en enceinte confinée et sous atmosphère contrôlée jusqu'à la disparition de l'activité chimique au sein et en surface de la couche de polymère déposée.

8. Procédé selon l'une quelconque des revendications 1 à 7 dans lequel le traitement thermique consiste en une calcination du matériau composite sous air à une température contrôlée supérieure ou égale à 450°C conduisant à la minéralisation partielle ou totale de la couche polymérique du matériau composite.

9. Procédé selon la revendication 8 dans lequel le traitement thermique est effectué à une température d'environ 600°C ou supérieure de sorte de conduire à la minéralisation complète de la couche polymérique du matériau composite.

10. Matériau composite, notamment obtenu par la mise en oeuvre du procédé selon la revendication 9, **caractérisé en ce qu'**il est formé d'un substrat en acier inoxydable à la surface duquel est accrochée une couche inorganique amorphe comportant une espèce chimique active solide.

11. Utilisation d'un matériau composite selon la revendication 10 ou obtenu par la mise en oeuvre du procédé selon l'une quelconque des revendications 1 à 9 comme support de catalyse.

12. Utilisation d'un matériau composite selon la revendication 10 ou obtenu par la mise en oeuvre du procédé selon l'une quelconque des revendications 1 à 9 comme intermédiaire favorisant l'accroche d'un catalyseur.

13. Utilisation d'un matériau composite selon la revendication 10 ou obtenu par la mise en oeuvre du procédé selon l'une quelconque des revendications 1 à 9 comme barrière à la diffusion des gaz.

14. Utilisation d'un matériau composite selon la revendication 10 ou obtenu par la mise en oeuvre du procédé selon l'une quelconque des revendications 1 à 9 comme protection contre les corrosions sèche ou humide.

15. Utilisation d'un matériau composite selon la revendication 10 ou obtenu par la mise en oeuvre du procédé selon l'une quelconque des revendications 1 à 9 comme couche de protection mécanique.

16. Utilisation d'un matériau composite selon la revendication 10 ou obtenu par la mise en oeuvre du procédé selon l'une quelconque des revendications 1 à 9 comme couche de lubrification mécanique de pièces inox de convoyage.
